# EUROPÄISCHE PATENTSCHRIFT

(11) **EP 1 690 298 B1**
(45) Veröffentlichungstag und Bekanntmachung des Hinweises auf die Patenterteilung: **13.08.2008**
(21) Anmeldenummer: 04802880.7
(22) Anmeldetag: 06.12.2004
(51) Int. Cl.: H01L 31/10, H01L 31/0224, H01L 31/02, H01L 27/144

(54) **FOTODETEKTOR MIT TRANSIMPEDANZ-VERSTÄRKER UND AUSWERTEELEKTRONIK IN MONOLITHISCHER INTEGRATION UND HERSTELLUNGSVERFAHREN**
PHOTODETECTOR COMPRISING A MONOLITHICALLY INTEGRATED TRANSIMPEDANCE AMPLIFIER AND EVALUATION ELECTRONICS, AND PRODUCTION METHOD
PHOTODETECTEUR A AMPLIFICATEUR TRANSIMPEDANCE ET ELECTRONIQUE D'EVALUATION EN INTEGRATION MONOLITHIQUE ET SON PROCEDE DE PRODUCTION

(30) Priorität: 06.12.2003 DE 10357135
(43) Veröffentlichungstag der Anmeldung: 16.08.2006
(73) Patentinhaber: X-FAB Semiconductor Foundries AG, 99097 Erfurt (DE); Melexis GmbH, 99097 Erfurt (DE)
(72) Erfinder: BACH, Konrad, 99189 Tieftal (DE); HOELKE, Alexander, 99085 Erfurt (DE); ECKOLDT, Uwe, 99448 Hohenfelden (DE); EINBRODT, Wolfgang, 99817 Eisenach (DE); STAHL, Karl-Ulrich, 99084 Erfurt (DE)
(74) Vertreter: Leonhard, Frank Reimund
(86) Internationale Anmeldenummer: PCT/DE2004/002672
(87) Internationale Veröffentlichungsnummer: WO 2005/057667

(56) Entgegenhaltungen:
- WO-A-02/33755
- US-A1- 2003 015 767
- US-A1- 2003 122 210
- KYOMASU M: "DEVELOPMENT OF AN INTEGRATED HIGH SPEED SILICON PIN PHOTODIODE SENSOR" IEEE TRANSACTIONS ON ELECTRON DEVICES, IEEE INC. NEW YORK, US, Bd. 42, Nr. 6, 1. Juni 1995 (1995-06-01), Seiten 1093-1099, XP000517156 ISSN: 0018-9383
- HOBENBILD M ET AL: "High-speed photodiodes with reduced dark current and enhanced responsivity in the blue/uv spectra" ELECTRON DEVICES FOR MICROWAVE AND OPTOELECTRONIC APPLICATIONS, 2003. EDMO 2003. THE 11TH IEEE INTERNATIONAL SYMPOSIUM ON 17-18 NOV. 2003, PISCATAWAY, NJ, USA,IEEE, 17. November 2003 (2003-11-17), Seiten 60-65, XP010678515 ISBN: 0-7803-7904-7

## Beschreibung

Es wird der konstruktive Aufbau eines Fotodetektors für geringe zu verarbeitende Lichtleistungen beschrieben, bei dem das fotoempfindliche Element (Fotozelle) mit einem Transimpedanz-Verstärker und entsprechender Auswerteelektronik monolithisch integriert ist, wobei eine vertikale Anordnung des fotoempfindlichen Elements und der elektronischen Schaltungen vorgeschlagen wird. Das hat die Vorteile der Erhöhung der Empfindlichkeit des Fotodetektors und der Platzersparnis an Chipfläche (Einchip-Lösung). Bei der Montage ergibt sich eine Kostenersparnis, da das Chip-Gehäuse kleiner und einfacher gestaltet werden kann.

Bei fotoelektrischen Systemen wie z. B. Optokopplern, Infrarot-Empfänger Schaltkreisen für IR-Fernbedienungen, Bildsensoren oder CD/DVD Fotodetektor-ICs existieren aufgrund der stark unterschiedlichen Anforderungen an die "Licht-zu-Spannungs-Wandlung" verschiedene technologische Realisierungskonzepte. Man unterscheidet voll integrierte Schaltkreise, die Detektor (meist eine Fotodiode) und die dazugehörige Elektronik nebeneinander auf einem Chip vereinen von Zweichip-Lösungen, bei denen der Detektor als separates Chip über einen Bonddraht mit der Verstärker- und Auswerteelektronik elektrisch verbunden wird.

Voll integrierte Lösungen ermöglichen u. A. die unmittelbare Signalverarbeitung und sind dadurch besonders für sehr hohe Geschwindigkeiten/Datenraten geeignet (z.B. CD/DVD PDIC's - PDIC sind Photodetector Integrated Circuits). Voll integrierte Systeme sind unverzichtbar, wenn mehrere optische Signale örtlich eng benachbart und zeitgleich zu detektieren sind (z.B. Scanner-Zeilen, Bildsensoren, Messaufgaben).

Für Anwendungen mit geringen zu verarbeitenden Lichtleistungen sind große Detektorflächen notwendig. Diese können nicht mehr wirtschaftlich mit den signalverarbeitenden Schaltungsteilen gemeinsam integriert werden. Der Grund hierfür liegt darin, daß durch die integrierte Verstärkungs- und Auswerteelektronik komplizierte und somit teure Fertigungsprozesse (CMOS, BiCMOS) zum Einsatz kommen. Für die technologisch eher anspruchslose große Detektorfläche (z.B. Fotodiodenfläche) würden so die gleichen hohen technologiebedingten Kosten entstehen. Daher werden in den für geringe Lichtleistungen heute vorhandenen Zweichip-Lösungen für die verschiedenen Chips des Systems den Erfordernissen optimal angepaßte Halbleitertechnologien verwendet. Es entstehen aber dadurch zusätzliche Montagekosten, ein erhöhter Platzbedarf, und somit größere Gehäuse. Durch die elektrische Verbindung des Detektorchips mit dem signalverarbeitenden IC mittels Bondverbindungen kann sich außerdem eine erhöhte Störanfälligkeit durch elektromagnetische Einstrahlung ergeben. Das ist insbesondere bei konventionellen IR-Receiver Modulen für Infrarot-Fernbedienungen der Fall, die in Fernsehgeräten in der Umgebung von Bildröhren oder LC-Displays montiert sind. Dies ist nur durch kompliziertere und somit teurere Gehäuse zu kompensieren, siehe auch **Datenblatt Sharp,** Anlage GP1UE26RK.pdf. Das Dokument "Development of an integrated high speed silicon PIN photodiode sensor", Kyomasu, IEEE Transactions on Electronic Devices, No. 6, 6. Juni 1995, Seiten 1093 bis 1099, beschreibt einen Photodetektor mit integrierter Auswerteelektronik. WO 02/33755 A beschreibt einen Photodetektor mit CMOSintegrierten Photodioden.

Der Erfindung liegt **die Aufgabe zugrunde**, einen Fotodetektor so zu gestalten, daß die geschilderten Nachteile, die sich bei Detektoren für niedrige zu verarbeitende Lichtleistungen beim Stand der Technik ergeben, wenn es um die monolithische Integration mit der Auswerteelektronik geht, überwunden werden.

Gelöst wird diese Aufgabe mit den im Anspruch 1 oder 7 angegebenen Merkmalen.

Der Gegenstand des Anspruchs 1 weist die Vorteile auf, daß die fotoempfindliche Fläche des Detektors sich nahezu über die ganze Fläche ausdehnen kann, die der Chipgröße entspricht und diese Flächengröße auch zur Integration der Verstärkerschaltung und/oder der weiteren Signalverarbeitung verwendet werden kann. Der technologische Fertigungsaufwand ist dabei durch die vertikale Verbindung des Fotozellenbereichs mit der integrierten Schaltung über vertikal (parallel zu der Chipnormalen) verlaufende Dotierkanäle, z.B. durch einen modifizierten Isolationsgraben (Trench) geringfügig erhöht; die benötigte Fläche und andere Folgekosten für das Gesamtsystem sinken jedoch überproportional. Aufgrund der kompakten Bauweise ergeben sich außerdem parametrische Vorteile gegenüber konventionellen Zweichip-Lösungen.

Vorteilhafte Ausgestaltungen des Gegenstandes des Anspruchs 1 sind in den abhängigen Ansprüchen angegeben.

Hierbei ist insbesondere vorteilhaft der in seiner Ausgestaltung als elektrische Verbindung zwischen der Fotozelle und der elektronischen Schaltung benutzte (modifizierte) Trench.

Die Erfindung soll anhand von Beispielen näher erläutert werden. Die Figuren sind selbsterklärend und bedürfen nur einer kurzen näheren Erläuterung.
- **Figur 1**: ist eine schematische Darstellung eines ersten Beispiels der erfindungsgemäßen vertikalen Anordnung von Fotozelle 20 und elektronischen Schaltungen 30, elektrisch verbunden 40 durch einen modifizierten Graben (Trench), alles in monolithischer Integration.
- **Figur 2**: ist eine schematische Darstellung eines vertikal integrierten Detektorsystems in einem Gehäuse 60, wobei die einhüllende Verschlußmasse 61 für Licht der Signalwellenlänge transparent ist.

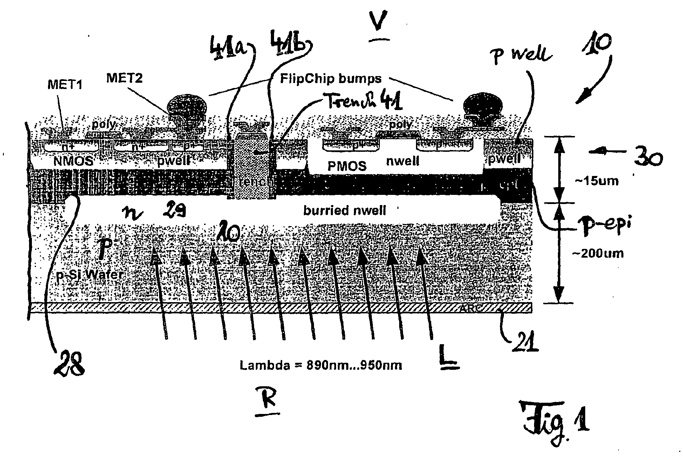

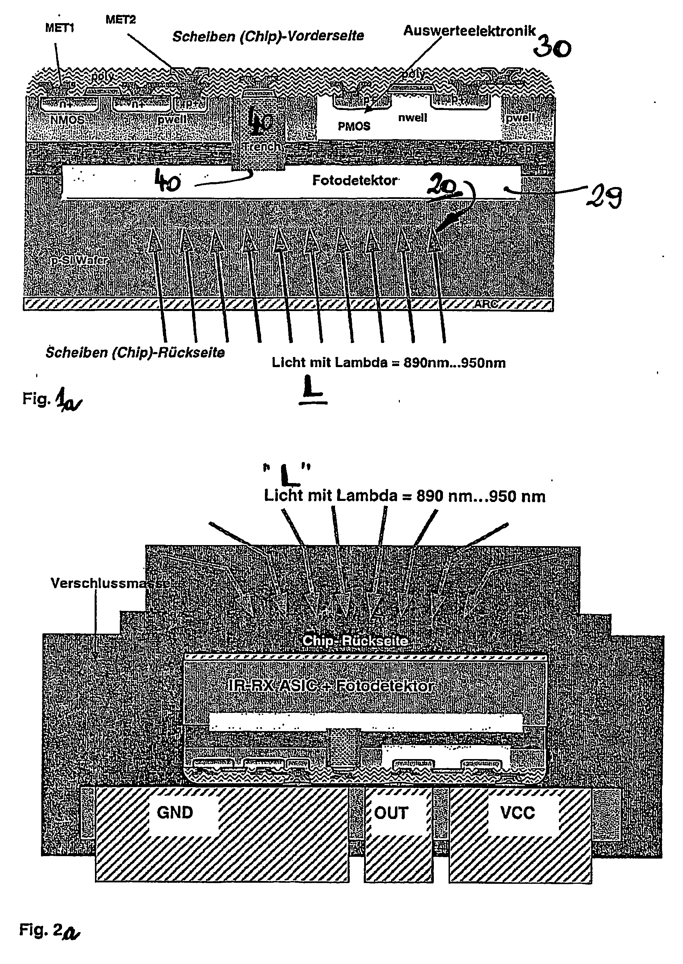

- **Figur 1a**: ist eine schematische Darstellung eines weiteren Beispiels der erfindungsgemäßen vertikalen Anordnung von Fotozelle und elektronischen Schaltungen, elektrisch verbunden durch einen modifizierten Graben (Trench), in monolithischer Integration.

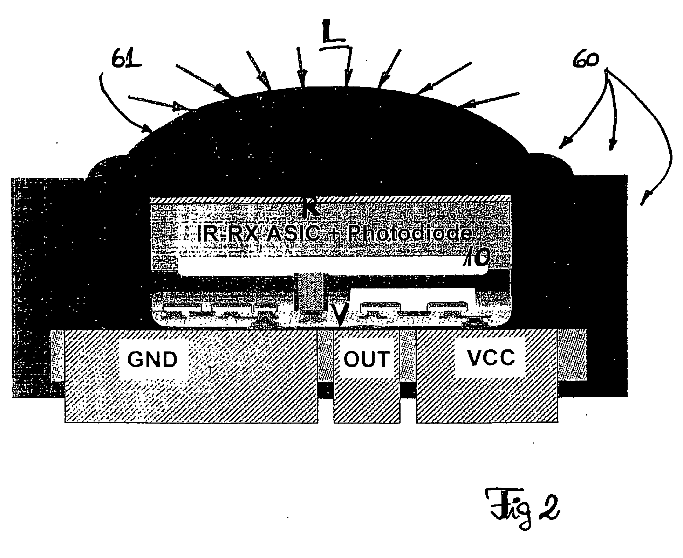

- **Figur 2a**: ist eine weitere schematische Darstellung eines vertikal integrierten Detektorsystems im Gehäuse, wobei die einhüllende Verschlußmasse für Licht der Signalwellenlänge transparent ist.

Zur Herstellung eines monolithischen Fotodetektors 10 kann folgendermaßen vorgegangen werden:

Ausgangsmaterial für alle Beispiele ist eine hochohmige Siliziumscheibe (100 ... 1000 Ohm*cm), zum Beispiel p-leitend. Dorthinein erfolgt eine maskierte (maskenbegrenzte) Umdotierung z.B. mit Phosphorionen-Implantation von der einen Scheibenseite V her. Die Maske kann jeweils fast die gesamte spätere Chipgröße öffnen. Auf eine geeignete Ausheilung (die mit Oxidation einhergehen kann, wobei deren Stufe dann als Justierhilfe dient) folgt dann eine Epitaxie mit demselben Leitungstyp wie die Ausgangsscheibe auf der nicht entgegengesetzten Scheibenseite V mit einer höheren Dotierung (5 ... 50 Ohm*cm) und einer Dicke im Bereich 10 ... 25 µm.

Durch diese Epitaxieschicht 28 werden lokale Dotierungen zur Kontaktierung der nunmehr vergrabenen umdotierten Schicht 29 eingebracht, die den wesentlichen Teil der Fotozelle bildet. Dies kann durch eine bekannte Sinker-Diffusion erfolgen.

In dem gezeigten Beispiel wird die Dotierung erzeugt, indem tiefe Isoliergräben 41 (Trenchs) bis in die vergrabene Schicht 29 geätzt werden und dann deren Seitenwände 41a. 41b mittels gezielt geneigter lonenimplantation dotiert werden. Danach werden die Öffnungen mit Polysilizium aufgefüllt.

Es ist ebenfalls möglich, die Trenngräben mit dotiertem Polysilizium aufzufüllen und die erwähnte Seitenwandimplantation wegzulassen.

Sind die Trenngräben geschlossen und planarisiert, beginnt ein normaler CMOS- oder BiCMOS-Prozess auf dieser epitaxierten Scheibenseite. Die gewissermaßen vergrabene Fotozelle 20 wird durch die Trenngräben 41 oder im anderen Beispiel Trenngräben 40 mit der Schaltung 30 an der Oberfläche verbunden.

Das Layout der Schaltung 30 ist so gestaltet, dass die Kontaktgebiete 41 oder 40 der vergrabenen Fotozelle (z.B. Diode) unmittelbar einbezogen werden, um so ideal kurze Verbindungswege zu realisieren. Elektrische Verbindungen (40) zwischen der Fotozelle und der elektronischen Schaltung sind mit einer Ausdehnung in Richtung zu einer Senkrechten zur Chipebene (der Normalen) vorhanden.

Nach Abschluss des konventionellen Halbleiter-Fertigungsprozesses erfolgt ein Abdünnen der gesamten Halbleiterscheibe auf der von der elektronischen Schaltung abgewandten Seite R und gegebenenfalls die Abscheidung einer Antireflexions-Schicht (ARC) 21 auf der Scheibenrückseite R. Der nach der Vereinzelung der Scheibe so hergestellte Chip wird dann kopfüber (also mit der Schaltung 30 nach unten) auf eine Leiterplatte montiert werden (Flip Chip-Technik), so dass die Fotozelle 20 mit ihrer Oberseite nach oben weist und zugänglich ist. Die Flip-Chip Technik ist günstig für die optimale Ausnutzung der vertikalen Integration des Detektors mit dem Schaltkreis.

Es ist jedoch auch möglich, das Chip konventionell mittels Bondverbindungen für die Betriebsspannung und das Ausgangssignal in einem "Clear-Mold" Gehäuse in "Chip on Lead"-Technik aufzubauen. Dabei ist eine Beleuchtung von der einen (Elektronik-Seite) oder der anderen Seite (Detektor-Seite) möglich.

Der für geringe zu verarbeitende Lichtleistungen vorgesehene Fotodetektor hat dadurch Transimpedanz-Verstärker und Auswerteelektronik in monolithischer Integration. Ein eigentlicher Fotozellenteil ist der einen Chipseite zugeordnet. Auf dieser fällt vorzugsweise das Licht ein. Elektronische Schaltungsteile sind auf der entgegen gesetzten Chipseite angeordnet. Elektrische Verbindungen sind zwischen der Fotozelle und der oder den elektronischen Schaltung(en) vorhanden, mit einer Ausdehnung in Richtung der Senkrechten zur Chipebene.

Die Fotodetektion des einfallenden Lichtes erfolgt dergestalt, daß das Licht auf die Rückseite oder Vorderseite fällt und je nach Wellenlänge in den ersten 10µm bis 20µm Elektronen/Loch-Paare generiert.

Diese diffundieren in die Raumladungszone der vergrabenen Diode und erzeugen dort je nach Beschaltung eine Fotospannung bzw. einen Fotostrom, dessen Signal von der darüberliegenden CMOS- oder BiCMOS-Schaltung 30 ausgewertet und verarbeitet wird, hier also Transimpedanz-Verstärker und Auswerteelektronik in monolithischer Integration vorliegen.

Die elektrischen Verbindungen zwischen dem Fotozellenteil und der elektronischen Schaltung sind durch in bestimmten Bereichen dotierte speziell verfüllte Gräben (Trenchs) gebildet, wobei die speziell verfüllten Gräben dotierte Seitenwände besitzen, weiche die elektrischen Verbindungen zwischen der Fotozelle und der elektronischen Schaltung herstellen.

Die speziell verfüllten Gräben können mit dotiertem Polysilizium gefüllt sein, welches die elektrischen Verbindungen zwischen der Fotozelle und der elektronischen Schaltung herstellt, wobei die speziell verfüllten Gräben auch zur elektrisch nicht-leitenden Trennung (Isolation) verschiedener Chip-Bereiche verwendet werden können.

### Bezugszeichenliste

- 10: Fotodetektor in monolithischer Integration (Einkristall)
- 20: Fotozellenteil
- 30: elektronische Schaltungsteile
- 40: elektrische Verbindungen
- **41**: leitfähiger Trenngraben
- 60: Gehäuse
- 61: Vergussmasse.

## Patentansprüche

1. **Fotodetektor** für geringe zu verarbeitende Lichtleistungen, aufgebaut in einer monolithischen Integration eines Chips, wobei der Fotodetektor einen Transimpedanz-Verstärker aufweist und die folgenden weiteren Merkmale besitzt:
- einen eigentlichen Fotozellenteil (20), welcher von einer Chipseite (R) lichtdurchlässig erreichbar ist, von der Licht (L) einfällt;
- einen elektronischen Schaltungsteil (30) in einer Auswerteelektronik, welcher auf der entgegengesetzten Chipseite angeordnet ist (V);
- elektrische Verbindungen (40,41) zwischen dem Fotozellenteil (20) und dem elektronische Schaltungsteil (30) mit einer Ausdehnung in Richtung parallel zu einer Senkrechten (Chipnormalen) bzw. mit einer Ausdehnung in Richtung senkrecht zur Chipebene.

2. Fotodetektor nach Anspruch 1, wobei die elektrischen Verbindungen zwischen dem Fotozellenteil (20) und dem elektronischen Schaltungsteil (30) durch in bestimmten Bereichen dotierte und speziell verfüllte Gräben oder Trenches gebildet sind (40,41), insbesondere durchgängig im kristallinen Halbleiter verlaufend.

3. Fotodetektor nach Anspruch 1 und 2, wobei die verfüllten Gräben (leitfähig) dotierte Seitenwände (41a,41b) besitzen, welche zumindest eine der elektrischen Verbindungen zwischen dem Fotozellenteil (20) und dem elektronische Schaltungsteil (30) herstellen.

4. Fotodetektor nach Anspruch 1 und 2, wobei verfüllte Gräben (40,41) mit dotiertem Polysilizium gefüllt sind, welches die elektrischen Verbindungen zwischen dem Fotozellenteil (20) und der elektronischen Schaltung herstellt.

5. Fotodetektor nach einem der Ansprüche 1 bis 4, wobei die verfüllten Gräben auch zur elektrisch nicht-leitenden Trennung als Isolation verschiedener Chip-Bereiche verwendet sind.

6. Fotodetektor nach einem der Ansprüche 1 bis 5, wobei dieser mit CMOS- oder BiCMOS-Prozessen hergestellt ist.

7. **Verfahren** zur Herstellung eines Fotodetektors gemäß Anspruch 1, für geringe zu verarbeitende Lichtleistungen, mit einem Transimpedanz-Verstärker und einer Auswerteelektronik (30) in monolithischer Integration, hauptsächlich mit folgenden Herstellungsschritten;
- Einsatz einer hochohmigem Scheibe aus Silizium zwischen 100 bis 1000 Ohm*cm eines insbes. p-leitenden ersten Leitungstyps als Ausgangsmaterial,
- maskenbegrenzte Umdotierung eines Bereiches zum entgegengesetzten Leitungstyp, insbes. durch eine lonenimplantation, zur Bildung einer umdotierten Schicht;
- Epitaxie zur Erzeugung einer Schicht der Dicke von im wesentlichen 10 µm bis 25µm und des ersten Leitungstyps des Ausgangsmaterials mit einer Dotierung im Bereich von 5 bis 50 Ohm*cm auf der einen Scheibenseite;
- Kontaktierung der nunmehr vergrabenen umdotierten Schicht mittels einer Herstellung lokaler Dotierungen der Epitaxieschicht über eine Sinker-Diffusion oder über dotierte Bereiche enthaltende, verfüllte Gräben oder Trenches;
- Planarisierung zumindest der verfüllten Gräben der Oberfläche der Scheibenseite mit der Epitaxieschicht;
- Durchführung eines CMOS- oder BiCMOS-Prozesses zur Herstellung der integrierten elektronischen Schaltung (30) auf der einen Scheibenseite als epitaktisch behandelte Seite;
- Abdünnen der Scheibe auf der anderen Seite,
- Vereinzelung und Montage der Chips sowie Verschluss mit einer im spektralen Empfindlichkeitsbereich des Fotodetektors optisch transparenten Verschlussmasse (61).

8. Verfahren nach Anspruch 7, zur Herstellung eines Fotodetektors, wobei
- nach der Vereinzelung eine Montage des Chips mit der anderen Seite (Detektorseite) auf einen COL (Chip on Lead) Trägerstreifen erfolgt und eine elektrische Verbindung durch Bonddrähte in konventioneller Weise erfolgt.

9. Verfahren nach Anspruch 7, zur Herstellung eines Fotodetektors, wobei
- nach der Vereinzelung eine Montage des Chips auf einer Leiterplatte oder einen Chip-Trägerstreifen mit der Seite der elektronischen Schaltung (30) erfolgt;
- der montierte Chip (10) verschlossen wird mit einer im spektralen Empfindlichkeitsbereich des Fotodetektors optisch transparenten Verschlussmasse (61).

10. Fotodetektor nach Anspruch 1, wobei die Auswerteelektronik in monolithischer Integration, d. h. sowohl Fotozellenteil als auch Auswerteelektronik (20,30) im gleichen einkristallinen Halbleitermaterial realisiert ist,
wobei der vergrabene Fotozellenteil und der vertikal darüberliegend angeordnete elektronische Schaltungsteil der Chipvorderseite (V) zugeordnet sind;
die elektrischen Verbindungen in Form von Trenches (40, 41) zwischen dem Fotozellenteil und der elektronischen Schaltung in Richtung der oder parallel zur Chipnormalen vorhanden sind;
um zu detektierendes Licht von der Chiprückseite (R) einfallen zu lassen.

11. Monolithischer Fotodetektor nach Anspruch 10, wobei die Chiprückseite zur Aufnahme des zu detektierenden Lichts ausgebildet ist (vgl. Figur 1, 1a).

12. Monolithischer Fotodetektor nach Anspruch 10, wobei die elektrischen Verbindungen (40) zwischen dem Fotozellenteil und der elektronischen **Schaltung** durch in bestimmten Bereichen dotierte speziell verfüllte Gräben (Trenches) gebildet werden und sich ausschließlich innerhalb des einkristallinen Halbleitermaterials befinden.

13. Monolithischer Fotodetektor nach einem von Anspruch 10 bis 12, wobei die verfüllten, sich ausschließlich innerhalb des einkristallinen Halbleitermaterials befindlichen Gräben (40) durchgängig dotierte und somit durchgängig leitfähige Seitenwände (41a,41b) besitzen, welche die elektrischen Verbindungen zwischen der Fotozelle und der elektronischen Schaltung herstellen.

14. Monolithischer Fotodetektor nach einem der Ansprüche 10 bis 12, wobei die speziell verfüllten Gräben (41) mit dotiertem Polysilizium gefüllt sind, welches die elektrischen Verbindungen zwischen der Fotozelle und der elektronischen Schaltung herstellt.

15. Monolithischer Fotodetektor nach einem der Ansprüche 10 bis 14, wobei die verfüllten Gräben eine elektrisch nicht leitende Trennung (Isolation) verschiedener Chip-Bereiche vornehmen.

16. Monolithischer Fotodetektor nach einem der Ansprüche 10 bis 15, wobei dieser mit CMOS- oder BiCMOS- Prozessen hergestellt ist.

17. **Verfahren** nach Anspruch 7, **gekennzeichnet durch** folgende weitere Herstellungsschritte
17.1) Kontaktierung der maskenbegrenzten, vergrabenen umdotierten Schicht mittels speziell verfüllter Gräben oder Trenches,
17.2) Planarisierung der speziell verfüllten Gräben auf der Scheibenvorderseite,
17.3) Durchführung des CMOS- oder BiCMOS- Prozesses zur Herstellung der integrierten elektronischen Schaltung auf der Scheibenvorderseite (V);
17.4) Abdünnen der Halbleiterscheibe von der Scheibenrückseite her,
17.5) die Vereinzelung;
17.6) die Montage eines der vereinzelten Chips auf die Leiterplatte oder einen Chip-Trägerstreifen mit der Vorderseite als der Seite der elektronischen Schaltung nach unten;
17.7) der Verschluss mit einer im spektralen Empfindlichkeitsbereich des Fotodetektors optisch transparenten Verschlussmasse.

18. Verfahren nach Anspruch 17, wobei eine Reihenfolge durch die fortlaufende Nummerierung festgelegt ist.

19. Verfahren nach Anspruch 17, wobei die Schritte 17.1 und nachfolgend 17.2 immer nach der Epitaxie erfolgen, alternativ aber auch nach 17.3 oder innerhalb von Teilschritten des Schrittes 17.3 ausgeführt werden.

## Claims

1. **Photodetector** for low luminous powers to be processed, structured in a monolithic integration of a chip, wherein the photodetector has a transimpedance amplifier and has the following features:
- an actual photocell part (20), which can be reached in light-permeable manner from one chip side (R), from which light (L) is incident.
- an electronic circuit part (30) in evaluating electronics, which is arranged (V) on the opposite chip side;
- electrical connections (40, 41) between the photocell part (20) and the electronic circuit part (30) with expansion in the direction parallel to a perpendicular (chip normals) or with expansion in the direction vertical to the chip plane.

2. Photodetector according to claim 1, wherein the electrical connections are formed (40, 41) between the photocell part (20) and the electronic circuit part (30) by specially filled depressions or trenches which are doped in certain regions, in particular running generally in the crystalline semiconductor.

3. Photodetector according to claim 1 and 2, wherein the filled depressions have (conductively) doped side walls (41 a, 41 b), which produce at least one of the electrical connections between the photocell part (20) and the electronic circuit part (30).

4. Photodetector according to claim 1 and 2, wherein filled depressions (40, 41) are filled with doped polysilicon, which produces the electrical connections between the photocell part (20) and the electronic circuit.

5. Photodetector according to one of claims 1 to 4, wherein the filled depressions are also used for electrically non-conductive separation as insulation of various chip regions.

6. Photodetector according to one of claims 1 to 5, wherein the latter is produced using CMOS or BiCMOS processes.

7. **Process for producing** a photodetector according to claim 1, for low luminous powers to be processed, having a transimpedance amplifier and evaluating electronics (30) in monolithic integration, mainly having the following production steps;
- use of a high-ohmic wafer made from silicon between 100 to 1,000 Ohm*cm of an in particular p-conducting first conductivity type as starting material,
- mask-defined doping around a region to the opposite conductivity type, in particular by ion implantation, to form a doped layer;
- epitaxy to produce a layer of thickness of essentially 10 µm to 25 µm and of the first conductivity type of the starting material having doping in the range of 5 to 50 Ohm*cm on the one side of the wafer;
- contacting the now buried doped layer by means of producing local doping of the epitaxial layer via sinker diffusion or via filled depressions or trenches containing doped regions;
- planarising at least the filled depressions of the surface of the side of the wafer with the epitaxial layer;
- carrying out a CMOS or BiCMOS process to produce the integrated electronic circuit (30) on the one side of the wafer as an epitaxially treated side;
- thinning the wafer on the other side,
- separating and assembling the chips and sealing with a sealing composition (61) which is optically transparent in the spectral sensitivity range of the photodetector.

8. Process according to claim 7, for producing a photodetector, wherein
- after separation, assembly of the chip is effected with the other side (detector side) on a COL (Chip on Lead) carrier strip and electrical connection is effected in conventional manner by bonding wires.

9. Process according to claim 7, for producing a photodetector, wherein
- after separation, assembly of the chip on a printed circuit board or a chip carrier strip is effected with the side of the electronic circuit (30);
- the assembled chip (10) is sealed by a sealing composition (61) which is optically transparent in the spectral sensitivity range of the photodetector.

10. Photodetector according to claim 1, wherein the evaluating electronics are realised in monolithic integration, that is, both photocell part and evaluating electronics (20, 30) in the same monocrystalline semiconductor material,
wherein the buried photocell part and the electronic circuit part arranged vertically thereabove are assigned to the front side (V) of the chip;
the electrical connections in the form of trenches (40, 41) are present between the photocell part and the electronic circuit in the direction of the chip normals or parallel thereto;
in order to let light to be detected be incident from the rear side (R) of the chip.

11. Monolithic photodetector according to claim 10, wherein the rear side of the chip is designed to receive the light to be detected (see Figure 1, 1a).

12. Monolithic photodetector according to claim 10, wherein the electrical connections (40) between the photocell part and the electronic circuit are formed by specially filled depressions (trenches) which are doped in certain regions and are situated exclusively within the monocrystalline semiconductor material.

13. Monolithic photodetector according to one of claims 10 to 12, wherein the filled depressions (40) situated exclusively within the monocrystalline semiconductor material have generally doped and hence generally conductive side walls (41 a, 41 b), which produce the electrical connections between the photocell and the electronic circuit.

14. Monolithic photodetector according to one of claims 10 to 12, wherein the specially filled depressions (41) are filled with doped polysilicon, which produces the electrical connections between the photocell and the electronic circuit.

15. Monolithic photodetector according to one of claims 10 to 14, wherein the filled depressions perform electrically non-conductive separation (insulation) of various chip regions.

16. Monolithic photodetector according to one of claims 10 to 15, wherein the latter is produced using CMOS or BiCMOS processes.

17. Process according to claim 7, **characterised by** the following further production steps:
17.1) contacting the mask-defined, buried doped layer by means of specially filled depressions or trenches,
17.2) planarising the specially filled depressions on the front side of the wafer,
17.3) carrying out the CMOS or BiCMOS process for producing the integrated electronic circuit on the front side (V) of the wafer;
17.4) thinning the semiconductor wafer from the rear side of the wafer,
17.5) separation;
17.6) assembly of one of the separated chips on the printed circuit board or a chip carrier strip with the front side as the side of the electronic circuit towards the bottom;
17.7) sealing with a sealing composition which is optically transparent in the spectral sensitivity range of the photodetector.

18. Process according to claim 17, wherein a sequence is fixed by the consecutive numbering.

19. Process according to claim 17, wherein the steps 17.1 and subsequently 17.2 always take place after epitaxy, but alternatively are also executed after 17.3 or within the steps of step 17.3.

## Revendications

1. Photodétecteur pour le traitement de faibles puissances lumineuses, constitué dans une intégration monolithique d'une puce, où le photodétecteur présente un amplificateur de transimpédance et possède les autres caractéristiques suivantes :
- une partie cellule photoélectrique proprement dite (20), qui peut être atteinte depuis une face de la puce (R) laissant pénétrer la lumière, sur laquelle la lumière (L) est incidente ;
- une partie circuit électronique (30) dans un système électronique d'analyse, qui est disposée sur la face de la puce opposée (V) ;
- des connexions électriques (40, 41) entre la partie cellule photoélectrique (20) et la partie circuit électronique (30), avec une extension dans le sens parallèle à une perpendiculaire (normale de la puce) ou avec une extension dans le sens perpendiculaire au plan de la puce.

2. Photodétecteur selon la revendication 1, dans lequel les connexions électriques (40, 41) entre la partie cellule photoélectrique (20) et la partie circuit électronique (30) sont formées par des tranchées spécialement remplies et dopées dans certaines zones, notamment passant dans le semi-conducteur cristallin.

3. Photodétecteur selon la revendication 1 et 2, dans lequel les tranchées remplies possèdent des parois latérales dopées (pour être conductrices) (41a, 41b), qui produisent au moins une des connexions électriques entre la partie cellule photoélectrique (20) et la partie circuit électronique (30).

4. Photodétecteur selon la revendication 1 et 2, dans lequel les tranchées remplies (40, 41) sont remplies de polysilicium dopé, qui crée les connexions électriques entre la partie cellule photoélectrique (20) et le circuit électronique.

5. Photodétecteur selon l'une des revendications 1 à 4, dans lequel les tranchées remplies sont aussi utilisées pour la séparation électriquement non conductrice pour l'isolation des différentes zones de la puce.

6. Photodétecteur selon l'une des revendications 1 à 5, dans lequel celui-ci est fabriqué par des procédés CMOS ou BiCMOS.

7. Procédé de fabrication d'un photodétecteur selon la revendication 1, pour le traitement de faibles puissances lumineuses, avec un amplificateur de transimpédance et un système électronique d'analyse (30) en intégration monolithique, comprenant principalement les étapes de fabrication suivantes :
- l'utilisation d'une tranche de silicium ayant une résistance ohmique élevée entre 100 et 1000 ohm*cm d'un premier type de conduction, notamment conducteur p, comme matière de départ,
- la modification du dopage d'une zone, restreinte par un masque, en type opposé de conduction, notamment grâce à l'implantation d'ions, pour former une couche à dopage modifié ;
- l'épitaxie pour produire une couche d'une épaisseur de sensiblement 10 µm à 25 µm et du premier type de conduction de la matière de départ avec un dopage situé dans la plage de 5 à 50 ohm*cm sur une face de la tranche ;
- la mise en contact de la couche à dopage modifié, à présent enterrée, au moyen d'une création de dopages locaux de la couche épitaxique par le biais d'une diffusion par puits ou par le biais de tranchées remplies, contenant des zones dopées,
- la planarisation au moins des tranchées remplies de la surface de la face de la tranche avec la couche épitaxique ;
- la réalisation d'un procédé CMOS ou BiCMOS pour la production d'un circuit électronique intégré (30) sur l'une des faces de la tranche en tant que face traitée par épitaxie ;
- l'amincissement de la tranche sur l'autre face,
- l'individualisation et le montage des puces ainsi que le scellement avec une masse de scellement optiquement transparente (61) située dans la zone de sensibilité spectrale du photodétecteur.

8. Procédé selon la revendication 7, pour la fabrication d'un photodétecteur, dans lequel
- après l'individualisation, un montage de la puce s'effectue avec l'autre face (face du détecteur) sur une bande substrat COL (chip on lead = puce sur grille), et une connexion électrique s'effectue par le biais de fils de liaison de manière usuelle.

9. Procédé selon la revendication 7, pour la fabrication d'un photodétecteur, dans lequel
- après l'individualisation, un montage de la puce s'effectue sur une carte de circuits imprimés ou une bande substrat de puces avec la face du circuit électronique (30) ;
- la puce montée (10) est scellée avec une masse de scellement optiquement transparente (61) située dans la zone de sensibilité spectrale du photodétecteur.

10. Photodétecteur selon la revendication 1, dans lequel le système électronique d'analyse est en intégration monolithique, ce qui veut dire qu'aussi bien la partie cellule photoélectrique que le système électronique d'analyse (20, 30) sont réalisés avec le même matériau semi-conducteur monocristallin,
où la partie cellule photoélectrique enterrée et la partie circuit électronique disposée à la verticale par-dessus sont associées à la face avant de la puce (V) ;
les connexions électriques sont présentes sous forme de tranchées (40, 41) entre la partie cellule photoélectrique et le circuit électronique en direction ou en parallèle à la normale de la puce ;
pour que la lumière à détecter soit incidente depuis le dos de la puce (R).

11. Photodétecteur monolithique selon la revendication 10, dans lequel le dos de la puce est conçu pour absorber la lumière à détecter (cf. figure 1, 1a).

12. Photodétecteur monolithique selon la revendication 10, dans lequel les connexions électriques (40) sont formées entre la partie cellule photoélectrique et le circuit électronique grâce à des tranchées remplies spécialement, dopées dans certaines zones, et se trouvent exclusivement à l'intérieur du matériau semi-conducteur monocristallin.

13. Photodétecteur monolithique selon l'une des revendications 10 à 12, dans lequel les tranchées (40) remplies, se trouvant exclusivement à l'intérieur du matériau semi-conducteur monocristallin, possèdent des parois latérales (41a, 41b) dopées de manière traversante et donc conductrices de manière traversante, qui créent les connexions électriques entre la cellule photoélectrique et le circuit électronique.

14. Photodétecteur monolithique selon l'une des revendications 10 à 12, dans lequel les tranchées (41) spécialement remplies sont remplies de polysilicium dopé, qui crée les connexions électriques entre la cellule photoélectrique et le circuit électronique.

15. Photodétecteur monolithique selon l'une des revendications 10 à 14, dans lequel les tranchées remplies opèrent une séparation électriquement non conductrice (isolation) des différentes zones de la puce.

16. Photodétecteur monolithique selon l'une des revendications 10 à 15, dans lequel celui-ci est fabriqué par des procédés CMOS ou BiCMOS.

17. Procédé selon la revendication 7, **caractérisé par** les autres étapes de fabrication suivantes :
17.1) la mise en contact de la couche enterrée, restreinte par un masque, à dopage modifié, au moyen de tranchées spécifiquement remplies,
17.2) la planarisation des tranchées spécifiquement remplies sur la face avant de la tranche,
17.3) la réalisation du procédé CMOS ou BiCMOS pour fabriquer le circuit électronique intégré sur la face avant de la tranche (V) ;
17.4) l'amincissement de la tranche de semi-conducteur depuis le dos de la tranche,
17.5) l'individualisation ;
17.6) le montage d'une des puces individualisées sur la carte de circuits intégrés ou une bande substrat de puce avec la face avant pour face du circuit électronique tournée vers le bas ;
17.7) le scellement avec une masse de scellement optiquement transparente dans le domaine de sensibilité spectrale du photodétecteur.

18. Procédé selon la revendication 17, dans lequel un ordre est déterminé par la numérotation continue.

19. Procédé selon la revendication 17, dans lequel les étapes 17.1 et par la suite 17.2 s'effectuent toujours après l'épitaxie, en variante aussi cependant après l'étape 17.3 ou à l'intérieur des étapes de l'étape 17.3.
